# EUROPEAN PATENT SPECIFICATION

(11) **EP 2 145 229 B1**
(45) Date of publication and mention of the grant of the patent: **20.04.2016**
(21) Application number: 08788906.9
(22) Date of filing: 08.05.2008
(51) Int. Cl.: G03F 7/20, G03F 7/24

(54) **EXPOSING PRINTING PLATES USING LIGHT EMITTING DIODES**
BELICHTUNG VON DRUCKPLATTEN MITHILFE LICHTEMITTIERENDER DIODEN
EXPOSITION DE PLAQUES D'IMPRESSION À L'AIDE DE DIODES ÉLECTROLUMINESCENTES

(30) Priority: 08.05.2007 US 916738 P; 20.06.2007 US 945189 P; 21.06.2007 US 945439 P; 30.04.2008 US 112886; 30.04.2008 US 113001
(43) Date of publication of application: 20.01.2010
(60) Divisional application: 16000528.6
(73) Proprietor: Esko-Graphics Imaging GmbH, 25524 Itzehoe (DE)
(72) Inventor: SIEVERS, Wolfgang, 25569 Kremperheide (DE)
(74) Representative: Office Kirkpatrick
(86) International application number: PCT/IB2008/001900
(87) International publication number: WO 2008/135865

(56) References cited:
- JP-A- 2007 045 128
- US-A1- 2005 183 597
- US-B1- 6 683 421

## Description

### RELATED APPLICATIONS

The present invention claims benefit of priority of and is a conversion of U.S. Provisional Patent Applications Nos. 60/945,439 filed 21 June 2007, 60/945,189 filed 20 June 2007, and 60/916,738 filed 8 May 2007.

### FIELD OF THE INVENTION

The present invention relates generally to printing, and in particular to curing printing plates having photo-curable material thereon using a solid state source of radiation.

### BACKGROUND

Preparing printing plates such as photopolymer flexographic plates and letterpress printing plates coated with photopolymer material, such plates in general referred to as ``polymer plates") is being more and more automated. A typical process of preparing such printing plates includes starting with a plate that has an ablatable material thereon, imaging in a digital imager to ablate the ablatable material according to imaging data, and a curing process of the exposed plate that involves exposure to light energy, e.g., ultraviolet (UV) light energy. Automation often includes inline exposure to cure the plate inline after imaging.

Polymer plates as described herein include plates for flexography made of a material such as photopolymer material that can be cured by exposure to UV, and also letterpress plates (e.g., lithographic plates) that have a photopolymer material coated thereon that is exposed by UV material to cure the coating. Polymer plates as used herein also include cylinders with photo-curable coatings thereon, sometimes called polymer sleeves or photopolymer sleeves. Note that the term "polymer" is not meant to limit the composition of the photo-curable material, Any photo-curable material that is curable by UV radiation is included.

Many polymer plates are optimized for a 365 nm curing wavelength. Depending on the speed by which the polymer plate is imaged, there has to be sufficient UV power available to do sufficient UV curing of the polymer during the inline exposure. For 4 m²/h productivity, the UV power at 365 nm has to be around 150 Watts. State of the art systems that include such so called inline exposure typically use gas filled arc lamps to generate sufficiently high levels of UV energy in the required wavelength or wavelengths. Such arc lamps consume up to several Kilowatts of electrical power to provide the required amount of exposure energy. Furthermore, as much as 98% of this energy is converted into heat or other unwanted wavelengths, and needs to be filtered out and cooled away from the polymer plate. The conversion efficiency of such arc-lamp-based inline exposure systems is usually not better than 1.5% to 2%. Furthermore, such arc lamps run at high voltages, e.g., several hundred to several thousand Volts. Furthermore, such arc lamps typically need to be cooled, e.g., water cooled in order to remove the enormous amounts of waste heat and radiation not needed for the curing process.

The combination of the need for a relatively high voltage and for water or other types of cooling is potentially hazardous.

In addition to the hazards and the waste, heating of polymer plates has a negative impact on the homogeneity of halftone screen dots, e.g., has negative impact on the appearance of a homogeneous screened area. This can further increase the amount of UV energy necessary for curing.

Furthermore, some of the wavelengths produce by such arc lamps, e.g., radiation in the UV-C range can produce artifacts such as relatively brittle screen dots that can break off the plate after as few as a few hundred or perhaps a few thousand impressions. Therefore, there is a need to filter out undesired wavelengths other than the 365 nm range of wavelengths needed to cure a plate.

Such filtering of unwanted wavelengths further reduces the curing efficiency of the 365 nm range wavelength, so that the amount of 365 nm energy necessary for curing is raised.

Arc lamps also are known to produce a light source that is relatively not very diffuse. This causes very thin and small support shoulders of screen dots on a printing plate. Often complex reflector geometries are used in an attempt to compensate for the non-diffuse nature of the light from an arc lamp.

Furthermore, arc lamps are known to have a relatively limited life time. A life of between 500 and 2000 hours is typical.

### SUMMARY

It is an object of the present invention to solve the problems, discussed above. This object is achieved by the method and apparatus, as described in the claims hereafter.

The present invention is provided by a method of preparing a printing plate as described in claim 1.

According to a further embodiment of the present invention, the plate initially has ablatable material and the imaging includes ablating some of the ablatable material on the plate according to the imaging data to form an ablated plate, The applying of the UV radiation includes exposing the ablated plate to UV radiation to cure the plate.

According to a still further embodiment of the present invention, the applying of UV radiation is to cure an imaged photopolymer plate after ablatable material has been ablated from the surface of the plate according to imaging data.

According to a still further embodiment of the present invention, the LEDs are in the form of a plurality of arrays of LEDs.

According to a still further embodiment of the present invention, the ring or ring part is movable in the axial direction of the axis of rotation of the drum, wherein the imaging is by one or more modulated beams that move along the axial direction relative to the surface of the drum while the drum rotates during imaging, and wherein the ring or ring part moves with the one or more modulated beams during imaging after the one or more beams to expose the imaged plate to UV radiation.

According to a still further embodiment of the present invention, the LEDs extend across the length of the drum.

According to a still further embodiment of the present invention, the LEDs are mounted on a heatsink to remove heat generated during the applying of UV radiation. According to a still further embodiment of the present invention, the heatsink, includes channels for liquid and the method further comprises supplying cooling liquid through the channels to remove heat from the LEDs during operation.

According to a still further embodiment of the present invention, the method comprises forcing air onto the heatsink to remove the heat load by forced air cooling. According to a still further embodiment of the present invention, the divergence of the UV radiation is adjustable by tilting some of the LEDs differently with respect to the drum rotation axis so that the beams from the LEDs are in a plurality of directions to add diffusion to the beams.

According to a still further embodiment of the present invention, the LEDs are mounted on a plurality of panels, each panel having one or more LEDs, each panel tiltable so that by tilting the panels at a plurality of angles, a range of UV beam directions are obtained.

According to a still further embodiment of the present invention, the UV LEDs are of a plurality of wavelengths supplied by respective controllable power sources and the method further comprises controlling the spectral composition of the UV produced by the LEDs by controlling the respective power sources for the LEDs.

According to a still further embodiment of the present invention, the method comprises removing the imaged plate from the imaging device and applying UV radiation to the back of the printing plate using a plurality of UV emitting LEDs during or after the removing of the imaged plate.

According to a still further embodiment of the present invention, the method comprises removing the imaged plate from the imaging device and applying UV radiation to the front of the printing plate or to both the front and the back of the printing plate using a plurality of UV emitting LEDs during or after the placing of the plate or the removing of the imaged plate.

The invention provides also in an apparatus as described in claim 7.

According to a further embodiment of the present invention, the plate initially has ablatable material, and wherein the imaging ablates ablatable material on the plate according to the imaging data to form an ablated plate.

According to a still further embodiment of the present invention, the ring part is movable in the axial direction of the axis of rotation of the drum, and operative to move with the one or more laser beams during the imaging process after the one or more laser beams to expose the plate after imaging to UV radiation.

According to a still further embodiment of the present invention, the LEDs are arranged around part of the circumference on a ring part, and extend across the length of the drum.

According to a still further embodiment of the present invention, the apparatus further comprises a heatsink on which the LEDs are mounted whereby the heatsink removes heat generated during exposing to the UV radiation.

According to a still further embodiment of the present invention, the heatsink includes channels for liquid, such that, in operation, cooling liquid is supplied through the channels to remove heat from the LEDs during operation.

According to a still further embodiment of the present invention, the cooling liquid is water.

According to a still further embodiment of the present invention, the apparatus further comprises forced air cooling of the heatsink to remove the heat load by forced air cooling.

According to a still further embodiment of the present invention, the UV radiation has divergence that is adjustable by tilting some of the LEDs differently with respect to the drum rotation axis so that the beams from the LEDs are in a plurality of directions.

According to a still further embodiment of the present invention, the LEDs are mounted on a plurality of panels, each panel having one or more LEDs and each panel is tiltable so that by tilting the panels at a plurality of angles, a range of UV beam directions are obtained.

According to a still further embodiment of the present invention, the UV LEDs are of a plurality of wavelengths supplied by respective controllable power sources, such that the spectral composition of the UV produced by the LEDs is controllable by controlling the respective power sources for the LEDs.

According to a still further embodiment of the present invention, the apparatus comprises an unloading area onto which a plate is movable when unloaded from the drum and a plurality of UV emitting LEDs configured to apply UV radiation to the back of the plate during or after the removing of the imaged plate.

Particular embodiments may provide all, some, or none of these aspects, features, or advantages.

### DESCRIPTION OF THE DRAWINGS

FIG. 1A shows in a simple cross-sectional view of one example of an LED-based exposure system.
FIG. 1B shows a simplified perspective view of elements of one example of a LED-based exposure systems.
FIG. 2 shows the exposure system of the invention in which an LED holder that holds one or more arrays of LEDs is arranged as a segment of a ring rather than as the mounting ring of the embodiment of FIGS. 1A and 1B.
FIG. 3 shows an exposure system in which the LEDs are arranged in a segment that is moveable towards and away from the axis of rotation of the drum.
FIG. 4 is to show how a light source with relatively low diffusion results in a screen dot with a narrow support structure.
FIG. 5 is to show how a light source with relatively high diffusaion results in a screen dot with a relatively wide support structure.
FIG. 6 shows one embodiment of the invention in which a plurality of LED arrays are arranged at different angles.
FIG. 7A shows an embodiment of the invention in which a mounting ring is divided into segments that hold the LED arrays with each segment tiltable with respect to the drum's axis of rotation.
FIG. 7B shows an embodiment of a segment of a mounting ring that is tiltable with respect to the drum's axis of rotation and has LED arrays mounted on it.
FIG. 8 shows one embodiment of the invention in which the LED arrays are arranged in a line at the location where a polymer plate travels along during unloading from the drum such that the back of the plate can be exposed.
FIG. 9 shows another embodiment of the invention in which LED arrays of different wavelengths are used.

### DESCRIPTION OF EXAMPLE EMBODIMENTS

Embodiments of the present invention include an apparatus configured to expose a plate that has a photocurable material thereon, the exposing using light emitting diodes (LEDs) to cure of the photocurable material thereon. Embodiments further include a method of exposing a plate that has a photocurable material thereon, such as a polymer flexographic plate, a polymer-coated letterpress plate, or a polymer cylinder with UV radiation using LEDs rather than arc lamps.

Throughout the specification and claims, it is to be understood that by exposing a plate is meant exposing a plate that has a photocurable material thereon to cure the material thereon using UV radiation. Plates as described herein are plates that have a photocurable material thereon, and include polymer plates. Such a polymer plate may be a plate for flexography made of a photopolymer material that can be cured by exposure to UV. Such a polymer plate may alternately be a letterpress plate that has a photopolymer material coated thereon and that is exposed by UV material to cure the coating. Such a polymer plate may alternately be a plate on a cylinder. A plate on a cylinder may be a cylinder made of carbon fiber or glass fiber which is coated with a layer of photopolymer that is curable by UV radiation. Such cylinders with a plate thereon are sometimes referred to as polymer sleeves and photopolymer sleeves.

Thus the present invention covers the exposing of any plate of any shape that has photocurable material thereon, e.g., a photopolymer. The present invention is thus applicable to all printing plates on which curing by exposure to UV radiation is applicable.

The term printing plate is understood to mean such a plate herein.

### Overview

The present invention includes methods and apparatuses that include exposing a plate to UV radiation using UV emitting LEDs.

Particular embodiments include a method comprising: placing a printing plate on an imaging device; imaging the plate according to imaging data; and applying UV radiation using a plurality of UV emitting LEDs during the process of imaging of the printing plate. In one embodiment, the plate initially has ablatable material, and wherein the imaging includes ablating ablatable material on the plate according to the imaging data to form an ablated plate, and wherein the applying of the UV radiation includes exposing the ablated plate to UV radiation to cure the plate. The imaging device is an external drum imager that includes a drum that rotates during imaging.

Particular embodiments include a method comprising: placing a printing plate on an imaging device; imaging the plate according to imaging data; removing the imaged plate; and applying UV radiation to the back of the printing plate using a plurality of UV emitting LEDs during or after the removing of the imaged printing plate.

Particular embodiments include a method comprising: placing a printing plate on an imaging device; imaging the plate according to imaging data; removing the imaged plate; and applying UV radiation to the back or front of the printing plate or to both the front and the back of the printing plate using a plurality of UV emitting LEDs during or after the placing of the plate or the removing of the imaged printing plate.

Particular embodiments include an apparatus comprising: a rotatable imaging drum arranged to have a plate or a sleeve with a plate thereon, the drum operative to rotate during an imaging process; a source of one or more laser beams coupled to a source of image data and operable to image a plate on the drum, including moving in the direction of the axis of rotation of the drum during the imaging process; and a plurality of UV emitting LEDs operative to expose at least an imaged portion of the plate during the imaging process to cure the at least imaged portion of the plate.

In one embodiment, the plate initially has ablatable material, and wherein the imaging ablates ablatable material on the plate according to the imaging data to form an ablated plate. The plurality of LEDs are in the form of a plurality of arrays of LEDs and the LEDs are arranged around part of the circumference of the drum mounted on a ring part, wherein the distance from the ring part to the axis of rotation of the drum is adjustable to accommodate drums or sleeves of different diameters.

Particular embodiments may provide all, some, or none of these aspects, features, or advantages.

### Using UV LEDs

LEDs that produce energy in the wavelength range suitable for exposing polymer plates are already available, and are used, e.g., for curing inks, such as inkjet inks. However, the amount of energy required for UV curing of a plate is relatively high. The inventor has recognized that LEDs that can produce light in the useful UV wavelength range have reached a stage of development where they are not only rugged and reliable, but also deliver sufficient output powers, that is, if enough of them are used, sufficient energy is available for the curing of plates.

LED arrays which provide about 0.25 Watts of UV @ 365 nm are already available. For example, Opto Technology, Inc. of Wheeling, Illinois, USA, for example, has an array of LEDs packaged in a TO-66 package called "Shark" (TM) that can be mounted on a heatsink, and that produces UV at the 375 nm range. The company is planning a 365nm version that is in the wavelength range for curing printing plates. For 150 Watts of UV energy, a device with an array of 600 LEDs is usable for inline UV exposure of plates at an approximate rate of 4 m²/h.

The conversion efficiency for such LEDs is around 4 - 5 % which is twice as good as arc lamps.

Waste energy is converted into heat. One version of the arrays is on a package mountable on a heatsink. In one embodiment, the excess heat is removed by using water cooled heatsinks with the LEDs. This reduces the heat to which the polymer plates are exposed. Insulation material further can be sued to mask heat radiated from the heatsinks towards the plates.

Thus the inventor recognizes that LEDs need less energy not only because of their better electro/optical conversion efficiency but also due to better process efficiency.

Also LEDs are known to last longer than typical arc lamps. Given sufficient cooling, LEDs should be able to operate for more than 10,000 hours, which is 5 to 20 times more than typical arc lamps used for inline exposure.

Furthermore, LEDs are powered by relatively low voltage DC power compared to arc lamps.

Thus, the inventor recognizes that it is possible to use multiple UV LEDs, e.g., multiple UV LED arrays for plate curing.

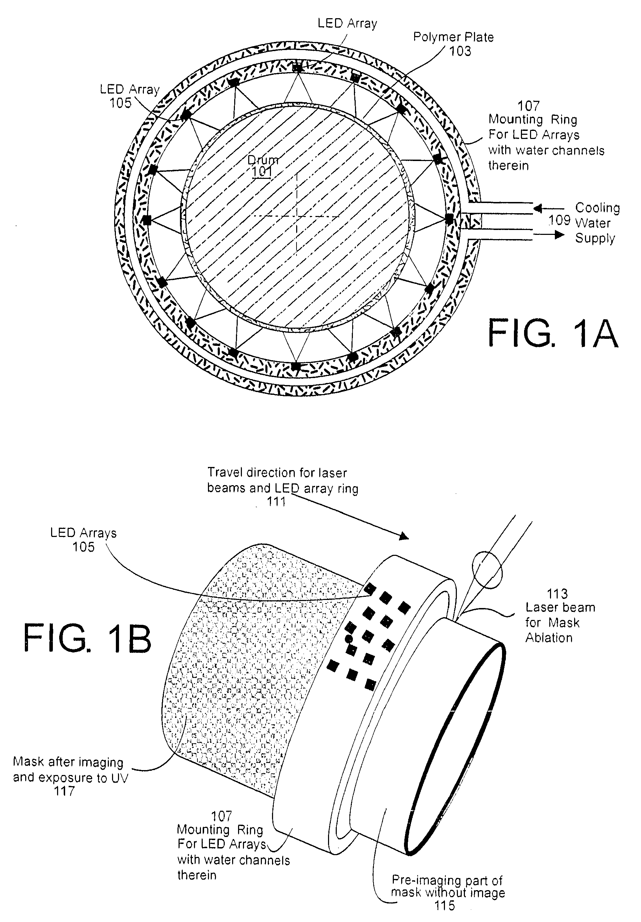

FIG. 1A shows in a simple cross-sectional view of an LED-based exposure system that works with an external drum digital imager that includes a rotating drum 101 around which a plate 103 such as a flexographic plate that has an ablatable mask thereon is placed to be imaged by one or more lasers modulated according to imaging data.

Define the axial direction as the direction of the axis of rotation of the drum. One embodiment of the digital imager includes the source of laser light 113 modulated by the imaging data moving in the axial direction during rotation of the drum so that the imaging data eventually images the whole drum by ablating the mask material.

One example includes a plurality of LED arrays 105 mounted on the inside surface of a mounting ring 107 made of heatsink material that is placed around the circumference of the drum 101 so that the LED arrays 105 expose the surface of the drum 101 or a plate 103 thereon when turned on. The mounting of the LED arrays 105 includes thermally coupling the LED arrays 105 to the heatsink material. One example uses common TO-66 packaged LEDs.

Note that, for the purpose of describing the invention, like elements that are used in different drawings or configurations have the same reference numeral. For example, LED arrays in any example embodiment of the invention use reference numeral 105. Those in the art will understand, however, that these arrays may not be identical or substitutable from embodiment to embodiment.

The mounting ring 107 is movable in the axial direction and is arranged to follow the modulated laser beam or beams 113, so that as the drum rotates and the plate 103 thereon is imaged, the plate 103 after imaging, i.e., with the mask thereon ablated according to the imaging data is exposed to UV radiation from the LED array(s) 105. The mounting ring 107 thus moves in the axial direction relative to the surface of the drum at the same rate and behind the modulated laser beam(s) 113.

In FIG, 1A, the mounting ring 107 included cooling channels-water channels-to which is coupled a supply of cooling liquid 109, e.g., water.

In one embodiment, as an additional measure, the inside surface of the mounting ring 107 other than where the LED arrays 105 emit their energy is insulated so that heat is not radiated in the direction of the drum 101.

FIG. 1B shows the arrangement in a simplified perspective view. The direction of motion of the laser beam(s) 113 and mounting ring 107 is shown as direction 111, and is shown left to right relative to the rotating drum 101.

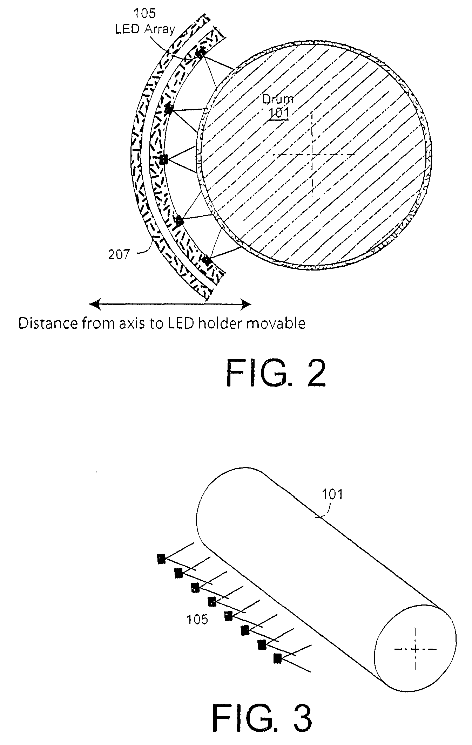

FIG. 2 shows an embodiment in which an LED holder 207 that holds one or more arrays of LEDs 105 is arranged as a segment of a ring rather than as the mounting ring 107 of FIGS. 1A and 1B. In one embodiment, the ring holder 207 covers about 90 degrees, so is a quarter-ring.

The invention includes a mechanism that allows the distance from the axis of rotation to the ring holder 207 to be varied. This allows the exposing unit to be used with drums of a plurality of diameters, with the distance changed to accommodate any particular diameter.

This embodiment is for drums, or sleeves that have relatively small diameters. The arrangement of FIG. 1 might not be suitable such cases, because there might not be sufficient surface to place a sufficient number of LEDs around the circumference.

One such embodiment is suitable for use with a range of drum or sleeve diameters.

FIG. 3 shows a simple perspective view of another example that like the embodiment of FIG. 2. is suitable for small diameter drums or sleeves, and also that provides for having different drums or sleeves of different sizes. In FIG. 3, the LED holder does not move in the axial direction, e.g., does not follow the laser beam in the axial direction, but is fixed in such a direction. The holder for the LED array(s) 105 extends the whole length of the drum. One such example still provides for varying the distance from the LED array(s) and the axis of rotation of the drum to accommodate different drums or sleeves of different diameters.

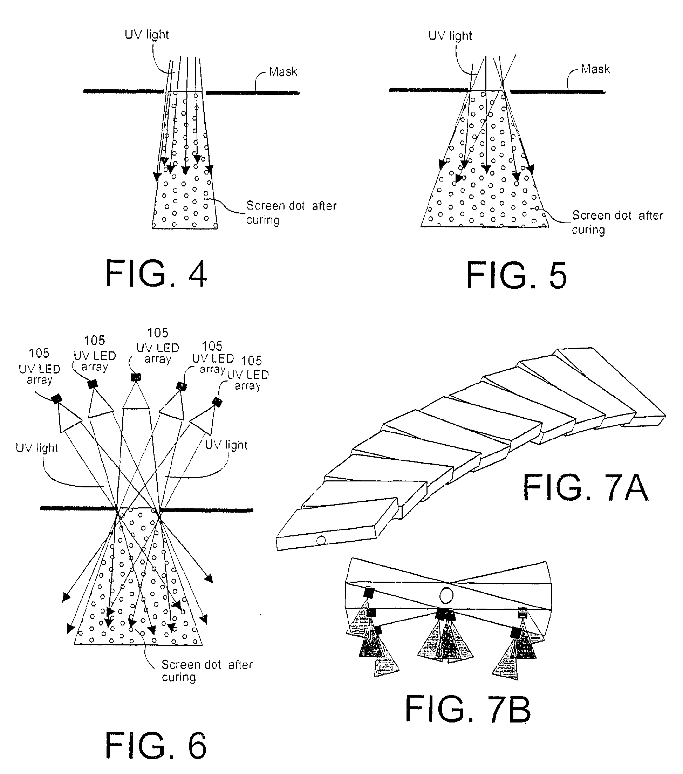

FIG.4 shows a problem that can occur with arc lamps without reflector geometries that avoid the relatively high brightness of such sources. Such arc lamps, without complex reflector structures, may cause small, steep support shoulders of the screen dots as shown in FIG. 4. These support shoulders give relatively little support during printing, and may cause the screen dot to bend under pressure as might occur during printing.

Complex reflector geometries are usually added to arc lamps to lower the brightness and produce more divergence and diffusion in the beam. Such lower brightness and high divergence and diffusion create broader shoulders in the cured polymer, as shown for a one halftone dot in FIG 5.

FIG. 6 shows how using a plurality of LEDs or LED arrays 105 can help produce a widely divergent (diffuse) beam. Each of the LED arrays 105 is placed to provide radiation at a slightly different angle. A relatively large number of such LED arrays is used in one embodiment, so that the LEDs can be aimed differently to produce a relatively divergent set of beams, resulting in broad shoulders. This is illustrated in FIG. 6 which shows five arrays 105 producing in combination a divergent set of beams, resulting, in this illustration, in a cured halftone dot that has relatively broad shoulders, compared, e.g., to the halftone dot shown in FIG. 4.

FIG. 7A shows a perspective view and FIG. 7B shows an end view of a part of a ring structure on which the LED arrays 105 are mounted. The rings structure is made up of a plurality of segments, onto which are mounted the LED arrays 105. The segments are each tilted at a different angle relative to the axis of rotation of the drum, so that beams at different directions are produced.

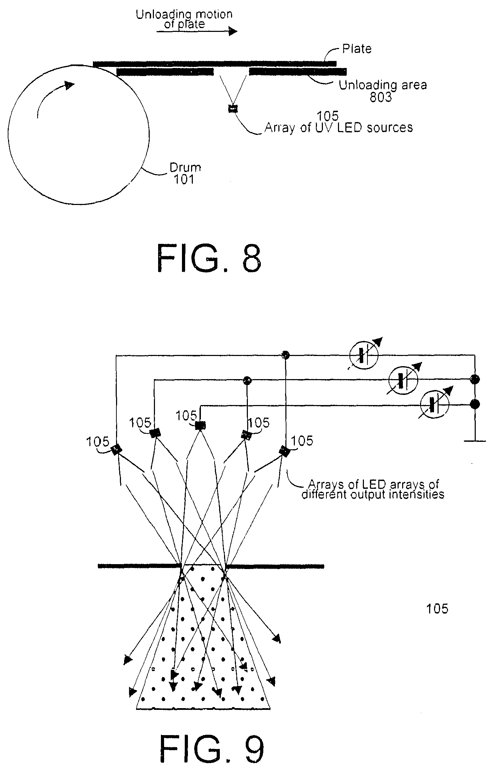

While the above describes using UV LED sources for curing of the plate material from the top through the mask, it is also known that back-exposure improves the quality of plates, e.g., flexographic plates. FIG. 8 shows in simplified form an apparatus usable to expose the back of such plates after imaging as part of the process of unloading a plate from the drum imager. An array of UV LEDs 105, or an array of arrays of UV LEDs' is placed along the width of an unloading area 803 onto which a plate is unloaded from an imaging drum 101 so that there is in-line exposure during unloading. The unloading area 803 has a window underneath that allows UV radiation from the bottom under the unloading area 803 to irradiate the back of the plate after imaging, e.g., in the process of unloading. The energy density is calculated so that the plate may be moved over the array of (arrays of) UV LEDs to sufficiently expose the back of the plate.

U.S. Provisional Patent Application No. 60/916,738 filed May 8, 2007 to inventors Wolterink et. al, and titled METHOD AND APPARATUS FOR LOADING AND UNLOADING FLEXOGRAPHIC PLATES FOR COMPUTER-TO-PLATE IMAGING INCLUDING SEPARATE LOADING AND UNLOADING AREA 803S described automatic inline exposure. An implementation of the present invention can be added to any of the embodiments described in U.S. Patent Application No. 60/916,738, in the form of a set of arrays of UV LEDs for front exposure, back exposure, or both front and back exposure.

FIG. 9 shows in simplified form another embodiment wherein the LED arrays 105 operate at a variety of wavelengths in order to influence one or more properties of the cured material. In the simplified drawing, three different UV LED wavelengths are used each to drive one or more arrays of LEDs, in this case, using three different power supplies. By having each set of LEDs of a particular wavelength driven by its own power supply that is independently controlled, the wavelength mixture, e.g., the relative amount of each wavelength for the exposure can be precisely controlled. By having individual control, not only the intensity, but the exposure time for each component wavelength can also be precisely controlled.

Yet another embodiment replaces common bank exposure systems that use one or more arc lamps for UV exposure of a plate after imaging by an exposure system that uses a plurality of LEDs or arrays of LEDs for the UV exposure. In one embodiment, such an exposure unit exposes the area of a whole plate. In another embodiment, the exposure unit exposes the width of a plate, and the plate travels relative to the source of UV radiation.

Many of the features described above are included in different embodiments of the LED exposure system that replaces a conventional bank exposure unit. In one embodiment, the exposure unit includes heatsink material on which the LEDs are mounted. In one version, the LEDs are oriented in a plurality of directions to produce UV beams of wider divergence, e.g., more disperse, so that the curing of the plate material produces better edges. In one version, LEDs of several wavelengths are used, each set of LEDs of different wavelengths driven by its independently controllable power source, so that the radiation produced can be tailored to be made up of different amounts of the wavelengths of the LEDs for spectral shaping.

Thus has been described use of UV LEDs or LED-arrays for curing photopolymer plates during the imaging process. Thus also has been described use of UV LEDs or LED-arrays for curing photopolymer plates after the imaging process. This may offer several advantages over state of the art arc lamps. The invention includes LEDs arranged on the inner side of a ring part which surrounds the surface of a rotatable drum of a drum imaging device. A photopolymer plate may be placed on the surface. The ring of LEDs travels in the axial direction during the laser imaging process to cure the imaged plate during the imaging process.

One feature compared to arc lamp curing is the relative absence of heat radiation, which otherwise may have negative impact on the curing process.

Another feature is that LEDs can be designed to only the wavelength (or wavelengths for a plurality of LEDs) needed for the curing process. Other wavelengths which reduce the quality of the cured plate are not present and so need not be filtered out.

Another feature is easy relative ease of adjustment of the curing light divergence by arranging the plurality of LEDs at various angles with respect to the plate surface. A more divergent set of beams may produce better curing than a less divergent set of beams.

### General

By the terms "polymer plate" and "photopolymer plate'' herein is meant a plate with any type of UV-curable material thereon. Today, such materials are photopolymers. However, the term "photopolymer'' is not meant to be limiting to a polymer composition. The inventor anticipates that in the future, there may be new materials and compositions that also are curable by UV radiation of a desired wavelength, and the invention is equally applicable to plates having such material thereon.

Unless specifically stated otherwise, as apparent from the following discussions, it is appreciated that throughout the specification discussions utilizing terms such as "processing," "computing," "calculating," "determining''' or the like, refer to the action and/or processes of a computer or computing system, or similar electronic computing device, that manipulate and/or transform data represented as physical, such as electronic, quantities into other data similarly represented as physical quantities.

In a similar manner, the term "processor" may refer to any device or portion of a device that processes electronic data, e.g., from registers and/or memory to transform that electronic data into other electronic data that, e.g., may be stored in registers and/or memory. A "computer" or a "computing machine'' or a "computing platform" may include one or more processors.

Note that when a method is described that includes several elements, e.g., several steps, no ordering of such elements, e.g., steps is implied, unless specifically stated.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may.

Similarly, it should be appreciated that in the above description of example embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment.

In the description provided herein, numerous specific details are set forth. However, it is understood that embodiments of the invention may be practiced without these specific details. In other instances, well-known methods, structures and techniques have not been shown in detail in order not to obscure an understanding of this description.

As used herein, unless otherwise specified the use of the ordinal adjectives "first", "second", "third", etc., to describe a common object, merely indicate that different instances of like objects are being referred to, and are not intended to imply that the objects so described must be in a given sequence, either temporally, spatially, in ranking, or in any other manner.

In the claims below and the description herein, any one of the terms comprising, comprised of or which comprises is an open term that means including at least the elements/features that follow, but not excluding others. Thus, the term comprising, when used in the claims, should not be interpreted as being limitative to the means or elements or steps listed thereafter. For example, the scope of the expression a device comprising A and B should not be limited to devices consisting only of elements A and B. Any one of the terms including or which includes or that includes as used herein is also an open term that also means including at least the elements/features that follow the term, but not excluding others. Thus, including is synonymous with and means comprising.

Similarly, it is to be noticed that the term coupled, when used in the claims, should not be interpreted as being limitative to direct connections only. The terms "coupled" and "connected," along with their derivatives, may be used. It should be understood that these terms are not intended as synonyms for each other. Thus, the scope of the expression a device A coupled to a device B should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

## Claims

1. A method of preparing a printing plate comprising:
- placing a printing plate (103) with photo-curable material thereon on an imaging device being an external drum imager including a drum (101) that rotates during imaging;
- imaging the plate (103) according to imaging data; and
- applying UV radiation using a plurality of UV emitting LEDs (105) to cure the photo-curable material on the plate (103) during the process of imaging of the printing plate (103),
wherein the printing plate is a photopolymer flexographic plate, a photopolymer letterpress plate, or a photopolymer sleeve,
**characterised in that** 10 - the LEDs (105) are arranged around a part of the circumference of the drum (101) mounted
on a ring part (207), wherein the distance from the ring part (207) to the axis of rotation of the drum (101) is adjustable to accommodate drums or sleeves of different diameters.

2. A method as recited in claim 1, wherein the plate (103) initially has ablatable material, and wherein the imaging includes ablating some of the ablatable material on the plate (103) according to the imaging data to form an ablated plate, and wherein the applying of the UV radiation includes exposing the ablated plate to UV radiation to cure the plate (103).

3. A method as recited in any of the previous claims, wherein the applying of UV radiation is to cure an imaged photopolymer plate (103) after ablatable material has been ablated from the surface of the plate according to imaging data.

4. A method as recited in any of the claims 1 to 3, wherein the divergence of the UV radiation is adjustable by tilting some of the LEDs (105) differently with respect to the drum rotation axis so that the beams from the LEDs (105) are in a plurality of directions to add diffusion to the beams and/or wherein the LEDs (105) are mounted on a plurality of panels, each panel having one or more LEDs, each panel tiltable so that by tilting the panels at a plurality of angles, a range of UV beam directions are obtained.

5. A method as recited in any of the claims 1 to 4, wherein the UV LEDs (105) are of a plurality of wavelengths supplied by respective controllable power sources, further comprising:
- controlling the spectral composition of the UV produced by the LEDs (105) by controlling the respective power sources for the LEDs.

6. A method according to any of the claims 1 to 5 comprising:
- removing the imaged plate (103) from the imaging device; and
- applying UV radiation to the back of the printing plate (103) using a plurality of UV emitting LEDs (105) during or after the removing of the imaged plate (103), and/or
- applying UV radiation to the front of the printing plate (103) or to both the front and the back of the printing plate (103) using a plurality of UV emitting LEDs (105) during or after the placing of the plate (103) or the removing of the imaged plate

7. An apparatus comprising:
- a rotatable imaging drum (101) arranged to have a plate (103) or a sleeve with a plate (103) thereon, the drum (101) operative to rotate during an imaging process;
- a source of one or more laser beams (113) coupled to a source of image data and operable to image a plate (103) on the drum (101), including moving in the direction of the axis of rotation of the drum (101) during the imaging process; and
- a plurality of UV emitting LEDs (105) operative to expose at least an imaged portion of the plate (103) during the imaging process to cure the at least imaged portion of the plate,
wherein the plate (103) is a photopolymer flexographic plate, a photopolymer letterpress plate, or a photopolymer sleeve,
the plurality of LEDs (105) being in the form of a plurality of arrays of LEDs (105) and
wherein the LEDs (105) are arranged around part of the circumference of the drum (101) mounted on a ring part (207), wherein the distance from the ring part (207) to the axis of rotation of the drum (101) is adjustable to accommodate drums or sleeves of different diameters.

8. An apparatus as recited in claim 7, further comprising a heatsink on which the LEDs (105) are mounted, the heatsink to remove heat generated during exposing to the UV radiation.

9. An apparatus as recited in any of the claims 7 and 8, wherein the UV LEDs (105) are of a plurality of wavelengths supplied by respective controllable power sources, such that the spectral composition of the UV produced by the LEDs is controllable by controlling the respective power sources for the LEDs.

10. An apparatus according to any of the claims 7 to 9 comprising:
- an unloading area (803) onto which a plate (103) is movable when unloaded from the drum (101); and
- a plurality of UV emitting LEDs (105) configured to apply UV radiation to the back of the plate (103) during or after the removing of the imaged plate (103).

11. An apparatus according to any of the claims 7 to 10 wherein the LEDs (105) extend across the length of the drum (101).

## Patentansprüche

1. Verfahren zum Vorbereiten einer Druckplatte, umfassend:
- Anordnen einer Druckplatte (103) mit einem darauf befindlichen lichthärtbaren Material auf einer Bebilderungsvorrichtung, die eine externe Abbildungstrommel mit einer Trommel (101) ist, die während der Bildverarbeitung dreht;
- Bebildern der Platte (103) gemäß Bildgebungsdaten; und
- Anwenden von UV-Strahlung unter Verwendung von mehreren UV ausstrahlenden LEDs (105) zum Härten des lichthärtbaren Materials auf der Platte (103) während des Bildgebungsverfahrens an der Druckplatte (103),
wobei die Druckplatte eine Photopolymer-Flexodruckplatte, eine Photopolymer-Hochdruckplatte oder ein Photopolymer-Sleeve ist,
**dadurch gekennzeichnet, dass** die LEDs (105) um einen Teil des Umfangs der Trommel (101) angeordnet sind, der an einem Ringteil (207) montiert ist, wobei der Abstand von dem Ringteil (207) zur Drehachse der Trommel (101) einstellbar ist, um Trommeln oder Sleeves unterschiedlicher Durchmesser aufzunehmen.

2. Verfahren nach Anspruch 1, wobei die Platte (103) zunächst ein ablatierbares Material hat und wobei die Bebilderung ein Ablatieren von etwas ablatierbarem Material auf der Platte (103) gemäß den Bebilderungsdaten enthält, um eine ablatierte Platte zu bilden, und wobei das Anwenden der UV-Strahlung ein Belichten der ablatierten Platte mit UV-Strahlung enthält, um die Platte (103) zu härten.

3. Verfahren nach einem der vorangehende Ansprüche, wobei das Anwenden von UV-Strahlung zum Härten einer bebilderten Photopolymerplatte (103) dient, nachdem das ablatierbare Material von der Oberfläche der Platte gemäß Bebilderungsdaten ablatiert wurde.

4. Verfahren nach einem der Ansprüche 1 bis 3, wobei die Divergenz der UV-Strahlung durch unterschiedliches Kippen einiger der LEDs (105) in Bezug auf die Trommeldrehachse einstellbar ist, so dass die Strahlen von den LEDs (105) in mehrere Richtungen verlaufen, um den Strahlen Diffusion zu verleihen, und/oder wobei die LEDs (105) auf mehreren Tafeln montiert sind, wobei jede Tafel eine oder mehrere LEDs aufweist, wobei jede Tafel kippfähig ist, so dass durch Kippen der Tafeln in mehreren Winkeln ein Bereich von UV-Strahlrichtungen erhalten wird.

5. Verfahren nach einem der Ansprüche 1 bis 4, wobei die UV LEDs (105) mehrere Wellenlängen aufweisen, die von entsprechenden steuerbaren Leistungsquellen zugeleitet werden, des Weiteren umfassend:
- Steuern der Spektralzusammensetzung des von den LEDs (105) erzeugten UV durch Steuern der entsprechenden Leistungsquellen für die LEDs.

6. Verfahren nach einem der Ansprüche 1 bis 5, umfassend:
- Entfernen der bebilderten Platte (103) aus der Bebilderungsvorrichtung; und
- Anwenden einer UV-Strahlung an der Rückseite der Druckplatte (103) durch Verwenden mehrerer UV-ausstrahlender LEDs (105) während oder nach der Entfernung der bebilderten Platte (103) und/oder
- Anwenden einer UV-Strahlung an der Vorderseite der Druckplatte (103) oder sowohl an der Vorderseite wie auch der Rückseite der Druckplatte (103) durch Verwenden mehrerer UV-ausstrahlender LEDs (105) während oder nach der Platzierung der Platte (103) oder der Entfernung der bebilderten Platte.

7. Vorrichtung, umfassend:
- eine drehbare Bebilderungstrommel (101), die mit einer Platte (103) oder einem Sleeve mit einer darauf befindlichen Platte (103) angeordnet ist, wobei die Trommel (101) betriebsbereit ist, während eines Bebilderungsverfahrens zu drehen;
- eine Quelle eines oder mehrerer Laserstrahlen (113), die an eine Quelle von Bilddaten gekoppelt und betreibbar ist, eine Platte (103) auf der Trommel (101) zu bebildern, enthaltend ein Bewegen in die Richtung der Drehachse der Trommel (101) während des Bebilderungsverfahrens; und
- mehrere UV ausstrahlende LEDs (105), die betriebsbereit sind, zumindest einen bebilderten Abschnitt der Platte (103) während des Bebilderungsverfahrens zu belichten, um den zumindest einen bebilderten Abschnitt der Platte zu härten,
wobei die Platte (103) eine Photopolymer-Flexodruckplatte, eine Photopolymer-Hochdruckplatte oder ein Photopolymer-Sleeve ist,
wobei die mehreren LEDs (105) die Form von mehreren Gruppen von LEDs (105) aufweisen und wobei die LEDs (105) um einen Teil des Umfangs der Trommel (101) angeordnet sind, der an einem Ringteil (207) montiert ist, wobei der Abstand von dem Ringteil (207) zur Drehachse der Trommel (101) einstellbar ist, um Trommeln oder Sleeves unterschiedlicher Durchmesser aufzunehmen.

8. Vorrichtung nach Anspruch 7, des Weiteren umfassend eine Wärmesenke, auf der die LEDs (105) montiert sind, wobei die Wärmesenken zum Ableiten von Wärme dient, die während der Belichtung mit UV-Strahlung erzeugt wird.

9. Vorrichtung nach einem der Ansprüche 7 und 8, wobei die UV LEDs (105) mehrere Wellenlängen haben, die von entsprechenden steuerbaren Leistungsquellen zugeleitet werden, so dass die Spektralzusammensetzung des von den LEDs (105) erzeugten UV durch Steuern der entsprechenden Leistungsquellen für die LEDs steuerbar ist.

10. Vorrichtung nach einem der Ansprüche 7 bis 9, umfassend:
- eine Entladungsfläche (803), auf welche eine Platte (103) bewegbar ist, wenn sie von der Trommel (101) entladen wird; und
- mehrere UV ausstrahlende LEDs (105), die zum Anwenden von UV-Strahlung an der Rückseite der Platte (103) während oder nach der Entfernung der bebilderten Platte (103) gestaltet sind.

11. Vorrichtung nach einem der Ansprüche 7 bis 10, wobei sich die LEDs (105) über die Länge der Trommel (101) erstrecken.

## Revendications

1. Procédé de préparation d'une plaque d'impression comprenant :
- le placement d'une plaque d'impression (103) avec une matière photodurcissable dessus sur un dispositif d'imagerie qui est un imageur à tambour externe incluant un tambour (101) qui tourne pendant l'imagerie ;
- l'imagerie de la plaque (103) selon des données d'image ; et
- l'application de rayonnement UV en utilisant une pluralité de DEL émettant des UV (105) pour durcir la matière photodurcissable sur la plaque (103) pendant le processus d'imagerie de la plaque d'impression (103),
dans lequel la plaque d'impression est une plaque flexographique de photopolymère, une plaque d'impression typograhique de photopolymère, ou un manchon de photopolymère,
**caractérisé en ce que**
- les DEL (105) sont agencés autour d'une partie de la circonférence du tambour (101) monté sur une partie annulaire (207), dans laquelle la distance de la partie annulaire (207) à l'axe de rotation du tambour (101) est réglable pour loger des tambours ou des manchons de différents diamètres.

2. Procédé selon la revendication 1, dans lequel la plaque (103) a initialement une matière pouvant subir une ablation, et dans lequel l'imagerie inclut l'ablation d'un peu de matière pouvant subir une ablation sur la plaque (103) selon les données d'imagerie pour former une plaque ayant subi une ablation, et dans lequel l'application du rayonnement UV inclut l'exposition de la plaque ayant subi une ablation à un rayonnement UV pour durcir la plaque (103).

3. Procédé selon n'importe laquelle des revendications précédentes, dans lequel l'application de rayonnement UV sert à durcir une plaque de photopolymère (103) ayant subi une imagerie après que la matière pouvant subir une ablation a subi une abrasion depuis la surface de la plaque selon des données d'imagerie.

4. Procédé selon n'importe laquelle des revendications 1 à 3, dans lequel la divergence du rayonnement UV est réglable en inclinant certaines des DEL (105) différemment par rapport à l'axe de rotation de tambour de sorte que les faisceaux provenant des DEL (105) sont dans une pluralité de directions pour ajouter de la diffusion aux faisceaux et/ou dans lequel les DEL (105) sont montés sur une pluralité de panneaux, chaque panneau ayant une ou plusieurs DEL, chaque panneau pouvant basculer de sorte qu'en inclinant les panneaux à une pluralité d'angles, une plage de directions de faisceau UV est obtenue.

5. Procédé selon n'importe laquelle des revendications 1 à 4, dans lequel les DEL UV (105) ont une pluralité de longueurs d'onde alimentées par des sources de courant respectives pouvant être commandées, comprenant en outre :
- la commande de la composition spectrale des UV produits par les DEL (105) en commandant les sources de courant respectives pour les DEL.

6. Procédé selon n'importe laquelle des revendications 1 à 5 comprenant :
- l'enlèvement de la plaque ayant subi une imagerie (103) depuis le dispositif d'imagerie ; et
- application d'un rayonnement UV au dos de la plaque d'impression (103) en utilisant une pluralité de DEL émettant des UV (105) pendant ou après l'enlèvement de la plaque ayant subi une imagerie (103), et/ou
- l'application d'un rayonnement UV à l'avant de la plaque d'impression (103) ou tant à l'avant qu'au dos de la plaque d'impression (103) en utilisant une pluralité de DEL émettant des UV (105) pendant ou après le placement de la plaque (103) ou l'enlèvement de la plaque ayant subi une imagerie.

7. Appareil comprenant :
- un tambour d'imagerie rotatif (101) agencé pour avoir une plaque (103) ou un manchon avec une plaque (103) dessus, le tambour (101) étant opérationnel pour tourner pendant un processus d'imagerie ;
- une source d'un ou plusieurs faisceaux laser (113) couplés à une source de données d'image et pouvant être mise en oeuvre pour effectuer une imagerie d'une plaque (103) sur le tambour (101), incluant le déplacement dans la direction de l'axe de rotation du tambour (101) pendant le processus d'imagerie ; et
- une pluralité de DEL émettant des UV (105) opérationnelles pour exposer au moins une partie ayant subi une imagerie de la plaque (103) pendant le processus d'imagerie pour durcir la partie ayant au moins subi une imagerie de la plaque,
dans lequel la plaque (103) est une plaque flexographique de photopolymère, une plaque d'impression typograhique de photopolymère, ou un manchon de photopolymère,
la pluralité de DEL (105) étant sous la forme d'une pluralité de groupements de DEL (105) et dans lequel les DEL (105) sont agencés autour d'une partie de la circonférence du tambour (101) monté sur une partie annulaire (207), dans lequel la distance de la partie annulaire (207) à l'axe de rotation du tambour (101) est réglable pour loger des tambours ou des manchons de différents diamètres.

8. Appareil selon la revendication 7, comprenant en outre un dissipateur thermique sur lequel les DEL (105) sont montées, le dissipateur thermique servant à enlever la chaleur produite pendant l'exposition au rayonnement UV.

9. Appareil selon n'importe laquelle des revendications 7 et 8, dans lequel les DEL UV (105) ont une pluralité de longueurs d'onde alimentées par des sources de courant respectives pouvant être commandées, de sorte que la composition spectrale des UV produits par les DEL peut être commandée en commandant les sources de courant respectives pour les DEL.

10. Appareil selon n'importe laquelle des revendications 7 à 9 comprenant :
- une zone de déchargement (803) sur laquelle une plaque (103) est mobile quand elle est déchargée du tambour (101) ; et
- une pluralité de DEL émettant des UV (105) configurées pour appliquer un rayonnement UV au dos de la plaque (103) pendant ou après l'enlèvement de la plaque ayant subi une imagerie (103).

11. Appareil selon n'importe laquelle des revendications 7 à 10, dans lequel les DEL (105) s'étendent d'un bout à l'autre de la longueur du tambour (101).
